# EUROPÄISCHE PATENTANMELDUNG

(11) **EP 4 811 940 A1**
(43) Veröffentlichungstag der Anmeldung: **23.09.2026**
(21) Anmeldenummer: 25165202.0
(22) Anmeldetag: 21.03.2025
(51) Int. Cl.: H05K 7/14

(54) **MODULAR AUFGEBAUTES AUTOMATISIERUNGSSYSTEM**

(71) Anmelder: Siemens Aktiengesellschaft, 80333 München (DE)
(72) Erfinder: Auerswald, Christian, 09131 Chemnitz (DE); Dausend, Stefan, 95666 Mitterteich (DE); Traub, Andreas, 92224 Amberg (DE); Weigl, Simon, 93413 Cham (DE); Zurek, Frantisek, 09126 Chemnitz (DE)
(74) Vertreter: Siemens Patent Attorneys

(57) **Zusammenfassung**

Die Erfindung betrifft ein Modular aufgebautes Automatisierungssystem (1) da ein Bussteckverbinder (BS) in dem Bussteckverbinder-Raum (BSR) verschiebbar angeordnet ist, und der Bussteckverbinder (BS) einen Linksseitigen-Stecker (LBS), einen Rechtsseitigen-Stecker (RBS) und einen zum Modulträger (BC) angeordneten Rückwandbus-Stecker (RWS) umfasst, welcher ausgestaltet ist einen Modulrückwandbus-Gegenstecker (RWG) des Elektronikmodul (EM) aufzunehmen, können Modulträger (BC) durch Aneinanderreihen das Automatisierungssystem (1) aufbauen, wobei ein Bussteckverbinder (BS) eines Vorgänger-Modulträgers (BC) durch eine Linksverschiebung des Bussteckverbinders (BS) eines Nachfolger-Modulträgers (BC) mit diesem verbindbar ist, wodurch ein Rückwandbus für das modular aufbaubare Automatisierungssystem (1) gebildet ist.

## Beschreibung

Die vorliegende Erfindung betrifft ein modular aufgebautes Automatisierungssystem, insbesondere ein System zur Verteilung von I/O-Signalen eines Steuerungssystems über eine Leiterplatte. Solche Systeme werden typischerweise in industriellen Automatisierungsanwendungen eingesetzt, wo eine flexible und effiziente Verbindung zwischen Steuerungseinheiten und verschiedenen Sensoren und Aktoren erforderlich ist.

In der Automatisierungstechnik werden bei Steuerungssystemen und dezentralen Peripherielösungen über Ein-/Ausgabemodule benötigte Aktoren/Sensoren an die Ein- bzw. Ausgänge über Klemmen verbunden. Bei Serienmaschinen oder größeren Stückzahlen von gleichen Aufbauten oder Aufbauvarianten entsteht dabei ein hoher Arbeits- und Prüfaufwand. In solchen Fällen ist es vorteilhafter, die Signale nicht an den Klemmen des Steuerungsgerätes abzugreifen, sondern über Steckverbinder und beispielsweise vorkonfektionierte Kabel anzuschließen. Dazu muss allerdings das Steuerungssystem die Signale direkt auf eine kundenspezifische oder applikationsspezifische Leiterplatte ausgeben bzw. entgegennehmen. Die Leiterplatte weist wiederum Schnittstellen bzw. Steckverbinder für den anwendungsspezifischen Automatisierungsfall auf.

In der Veröffentlichung "Design-Guide zu EJ-Backplane für Twinsafe-Module" vom 29.01.2018 in der Version 1.5.1, wird bereits eine Lösung für anwendungsspezifische Aufbauten von Modulen und Steckverbindern auf einer Leiterplatte vorgeschlagen.

Das Dokument US 2004/201972 A1 offenbart einen modular aufgebautes Automatisierungssystem umfassend eine Haupteinheit mit einem Busanschluss-Steckverbinder, eine Mehrzahl an Modulen mit jeweils einem Bussteckverbinder, eine Rückwandbusplatine in einem Lagenaufbau mit Busleiterbahnen die an eine Mehrzahl an Modulsteckverbindern angeschlossen ist,
in denen die Bussteckverbinder der Module angeordnet sind, wobei eine Hauptplatine auf der eine Mehrzahl an Modulsteckverbindern angeordnet ist und wobei die Rückwandbusplatine in der Hauptplatine angeordnet ist, die Module sind dabei dazu ausgestaltet über die Bussteckverbinder mittels der Rückwandbusplatine mit der Haupteinheit zu kommunizieren, wobei die Busleiterbahnen und der Lagenaufbau der Rückwandbusplatine derart ausgestaltet sind, dass ein Schichtstapel die Busleiterbahnen und Kernmaterial umfasst.

Bei den bekannten modular aufgebauten Automatisierungssystem ist es von Nachteil, dass das Layout bzw. das Routing von einem Rückwandbus der aufgebrachten Module immer wieder neu erstellt werden muss und vom Hersteller der Module auf Fehlersicherheit überprüft werden muss.

Es ist Aufgabe der vorliegenden Erfindung, ein modular aufgebautes Automatisierungssystem bereitzustellen, das die Nachteile bekannter Systeme überwindet. Insbesondere soll das System eine effizientere Verteilung von I/O-Signalen ermöglichen, den Installationsaufwand reduzieren und gleichzeitig eine hohe Flexibilität und Kompatibilität mit bestehenden Komponenten gewährleisten.

Diese Aufgabe wird durch ein modular aufgebautes Automatisierungssystem mit den Merkmalen des Anspruchs 1 gelöst. Vorteilhafte Ausführungsformen sind in den abhängigen Ansprüchen angegeben.

Das erfindungsgemäße Automatisierungssystem umfasst eine Leiterplatte, auf der eine Mehrzahl von Anschlussmitteln und Signalsteckverbindern angeordnet sind. Die Anschlussmittel sind für den Anschluss an Prozess-Signalkabel ausgelegt und über Leiterbahnen der Leiterplatte mit den Signalsteckverbindern verbunden.

Ein wesentliches Merkmal der Erfindung ist der Modulträger, der ein Elektronikmodul aufnimmt. Der Modulträger weist einen Bussteckverbinder-Raum und einen Signalsteckverbinder-Raum auf. Im Bussteckverbinder-Raum ist ein verschiebbarer Bussteckverbinder angeordnet, der einen linksseitigen Stecker, einen rechtsseitigen Stecker und einen zum Modulträger angeordneten Rückwandbus-Stecker umfasst.

Durch Aneinanderreihen mehrerer Modulträger kann das Automatisierungssystem modular aufgebaut werden. Dabei wird der Bussteckverbinder eines Nachfolger-Modulträgers durch eine Linksverschiebung mit dem Bussteckverbinder des Vorgänger-Modulträgers verbunden, wodurch ein durchgehender Rückwandbus gebildet wird.

### Diese Lösung bietet mehrere Vorteile:

Reduzierte Installationszeit: Durch die Verwendung vorkonfektionierter Kabel und Steckverbinder wird der Verdrahtungsaufwand erheblich reduziert.

Flexibilität: Das System ermöglicht eine einfache Erweiterung und Anpassung durch das Hinzufügen oder Entfernen von Modulträgern.

Kompatibilität: Bestehende Elektronikmodule können weiterverwendet werden, was die Integrationskosten senkt.

Vereinfachte Zertifizierung: Da der Rückwandbus über zertifizierte Komponenten realisiert wird, vereinfacht sich der Zertifizierungsprozess für kundenspezifische Aufbauten.

Effiziente Signalverteilung: Die direkte Verbindung der I/O-Signale über die Leiterplatte optimiert die Signalführung und reduziert potenzielle Fehlerquellen.

Das erfindungsgemäße System kann durch verschiedene zusätzliche Merkmale weiter verbessert werden, wie in den abhängigen Ansprüchen beschrieben. Dazu gehören beispielsweise die Verwendung einer Busleiterplatte im Bussteckverbinder, die Integration eines Adaptermoduls zur Verbindung mit einer Haupteinheit, sowie die Implementierung eines Abschluss-Moduls mit Abschluss-Netzwerk und Speicherbaustein für die Teilnehmerkennung.

Um eine Haupteinheit anzuschließen ist zwischen der Haupteinheit und einem ersten Modulträger ein Adaptermodul angeordnet ist, wobei das Adaptermodul ausgestaltet ist, mit einer Adapterleiterplatte, auf welcher ein Adapter-Haupteinheitsverbinder und ein Adapter-Busverbinder versetzt zueinander angeordnet sind. Da insbesondere die Haupteinheit auf einer Hutschiene angeordnet ist, kann so ein Höhenunterschied der Steckverbinder überwunden werden.

Die Verbindung der Haupteinheit zu den Modulträger und damit den Elektronikmodulen wird über das Adaptermodul gelöst, welches den Höhenunterschied der Steckverbinder der auf Hutschiene montierten Haupteinheit und der auf Leiterplatte montierten Modulträger Steckplätze ausgleicht. Das Adaptermodul wird an den ersten Steckplatz montiert und der Rückwandbusstecker des ersten Steckplatzes nach links geschoben, um den Bus mit dem Adapter zu verbinden. Anschließend wird die Haupteinheit auf der Hutschiene nach rechts geschoben und mit dem Steckverbinder im Adaptermodul verbunden.

### Das Abschluss-Modul erfüllt folgende Aufgaben:

### Einen Rückwandbus-Abschluss:

Das Modul enthält ein Abschluss-Netzwerk für den Rückwandbus, was die Signalintegrität im System verbessert und Reflexionen am Busende verhindert.

### Eine Teilnehmerkennung:

Es beinhaltet einen Speicherbaustein für die Teilnehmerkennung, was die Konfiguration und Verwaltung des Gesamtsystems erleichtert. Das Abschluss-Modul meldet sich immer als letztes Modul.

### Modulare Integration:

Als Teil des modularen Systems kann es einfach hinzugefügt oder entfernt werden, was die Flexibilität des Gesamtaufbaus erhöht.

### Schutz und Abschirmung:

Durch die Anordnung in einem Abschluss-Modulträger mit einer Abschluss-Abdeckung wird das Modul geschützt und möglicherweise auch elektrisch abgeschirmt.

### Systemabschluss:

Es bildet einen definierten Abschluss des modularen Aufbaus, was sowohl elektrisch als auch mechanisch vorteilhaft sein kann.

### Mögliche Zusatzfunktionen:

Abhängig von der genauen Implementierung könnte das Modul zusätzliche Funktionen wie Diagnose oder Systemüberwachung übernehmen.

Diese Vorteile tragen zur Gesamteffizienz, Zuverlässigkeit und Flexibilität des modularen Automatisierungssystems bei.

Das Modular aufgebaute Automatisierungssystem kann leere Steckplätze, also Modulträger in denen kein Elektronikmodul steckt, enthalten, bspw. für zukünftige Erweiterungen/Optionen). Die Modulträger selbst können nicht direkt durch eine CPU oder die Haupteinheit erkannt werden. Es können nur die gesteckten Elektronikmodule abgefragt werden. Somit kann ein Leer-Steckplatz ohne Elektronikmodul nicht abgefragt werden. Leere Steckplätze zwischen bestückten Steckplätzen können indirekt erkannt werden. Wenn sich beispielweise Steckplatz Nr. 5 auf eine Abfrage meldet, Nr. 6 nicht, Nr. 7 nicht aber Nr. 8 wieder, dann ist davon auszugeben, dass die Steckplätze Nr. 6 und 7 zwar vorhanden sind, sonst könnte sich Nr. 8 nicht melden, aber die Elektronikmodule sind entweder defekt oder nicht vorhanden. Da optionale Steckplätze aber oft am Ende einer Station sind, können diese dann auf diese Art nicht erkannt werden. An dieser Stelle hilft das Abschluss-Modul. Durch seine Bauform ist es definitiv der letzte Bus-Teilnehmer. Rechts vom Abschluss-Modul kann nichts weiter angesteckt werden. Seine Adresse ist per Definition der letzte Steckplatz im System. Nach dem Servermodul kommt nichts mehr. In einem Speicherbaustein können Konfigurationsdaten abgespeichert werden.

Abdeckung des seitlichen Rückwandbus Anschlusses durch den Abschluss-Modulträger mit Berührungsschutz ist möglich. Eine passive Widerstandsschaltung zusammen mit einem Bus-ASIC stellen die Bus-Anschaltung dar.

Besonders vorteilhaft ist die Ausgestaltung des Modulträgers mit speziellen Befestigungsmitteln, die eine einfache und sichere Montage auf der Leiterplatte ermöglichen. Diese Befestigungsmittel umfassen bewegliche Betätigungsteile mit Rasthaken, die in Ausnehmungen der Leiterplatte eingreifen und so eine zuverlässige Fixierung gewährleisten.

Durch die beschriebene Lösung wird ein hochflexibles, modulares Automatisierungssystem geschaffen, das die Vorteile einer Backplane-Lösung mit der Kompatibilität zu bestehenden Modulen kombiniert. Dies ermöglicht Anwendern eine effiziente und kostengünstige Integration in ihre Automatisierungsumgebungen bei gleichzeitiger Reduzierung des Installations- und Wartungsaufwands.

Die Zeichnung zeigt ein Ausführungsbeispiel der Erfindung. Dabei zeigen
- FIG 1: einen Modulträger in einer perspektivischen Ansicht mit Sicht auf eine Linkeseite,
- FIG 2: den Modulträger in einer perspektivischen Ansicht mit Sicht auf eine Rechteseite,
- FIG 3: den Modulträger in einer Explosionszeichnung,
- FIG 4: eine Schnittdarstellung durch ein Führungsteil und ein Betätigungsteil,
- FIG 5: ein Betätigungsteil,
- FIG 6: einen Bussteckverbinder,
- FIG 7: der Modulträger mit Blick auf die Montageseite,
- FIG 8: eine perspektivische Darstellung eines Modulträgers mit eingestecktem Elektronikmodul,
- FIG 9: eine modulares Automatisierungssystem auf einer eiterplatte,
- FIG 10: eine weitere perspektivische Darstellung des Modulträgers mit eingestecktem Elektronikmodul,
- FIG 11: ein Adaptermodul,
- FIG 12: das Adaptermodul in einer Explosionszeichnung,
- FIG 13: ein Abschluss-Modul,
- FIG 14: eine Veranschaulichung der links-Verschiebung des Bussteckverbinders,
- FIG 15: ein Abschluss-Modulträger
- FIG 16: eine Veranschaulichung des Adaptermodul, und
- FIG 17: eine Veranschaulichung des Signalsteckverbinder-Raums.

Folgende Komponenten werden in den Figuren für den Aufbau eines modularen Automatisierungssystem aufgezeigt:
Eine Leiterplatte LP, sie bildet die Basis des Systems und ermöglicht die elektrische Verbindung zwischen den Komponenten.

Anschlussmittel B1,B2,B3,B4 dienen zum Anschluss von Prozess-Signalkabeln und sind auf der Leiterplatte LP angeordnet.

Signalsteckverbinder SS,SS1,SS2 nehmen die Modul-Steckverbinder der Elektronikmodule auf und sind mit den Anschlussmitteln über Leiterbahnen verbunden.

Modulträger BC nimmt das Elektronikmodul EM auf und ermöglicht die modulare Erweiterung des Systems.

Elektronikmodul EM enthält die eigentliche Elektronik für die Automatisierungsfunktionen.

Bussteckverbinder BS, umfasst einem Linksseitigen Stecker LBS, einem rechtsseitigen Stecker RBS und einem Rückwandbus-Stecker RWS. Ermöglicht die Verbindung zwischen den Modulträgern und bildet den Rückwandbus.

Haupteinheit IM steuert und koordiniert das gesamte Automatisierungssystem.

Adaptermodul AM verbindet die Haupteinheit mit dem ersten Modulträger und ermöglicht die Anpassung verschiedener Höhen.

Abschluss-Modul ASM enthält ein Abschluss-Netzwerk AN für den Rückwandbus und einen Speicherbaustein Mem für die Teilnehmerkennung.

Diese Komponenten bilden zusammen ein flexibles, modulares Automatisierungssystem, das einfach zu erweitern und an verschiedene Anforderungen anzupassen ist.

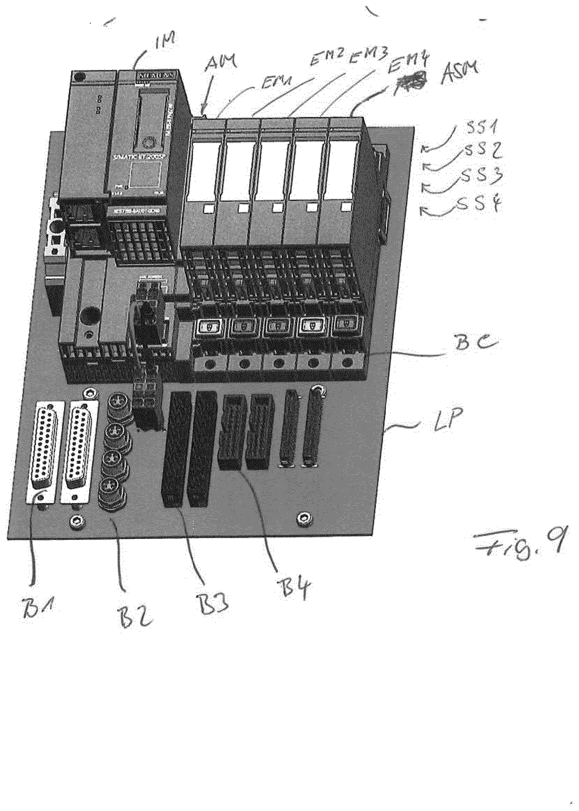

Gemäß FIG 9 ist ein modular aufgebautes Automatisierungssystem 1, wie es in der Prozessautomatisierung verwendet wird, dargestellt. Auf einer Leiterplatte LP ist eine Mehrzahl an Anschlussmitteln B1,B2,B3,B4 angeordnet. Die Anschlussmittel B1,B2,B3,B4 sind über Leiterbahnen der Leiterplatt LP mit einer Mehrzahl von Signalsteckverbindern SS, nämlich einem ersten Signalsteckverbinder SS1, einem zweiten Signalsteckverbinder SS2, einem dritten Signalsteckverbinder SS3 und einem vierten Signalsteckverbinder SS4 verbunden.

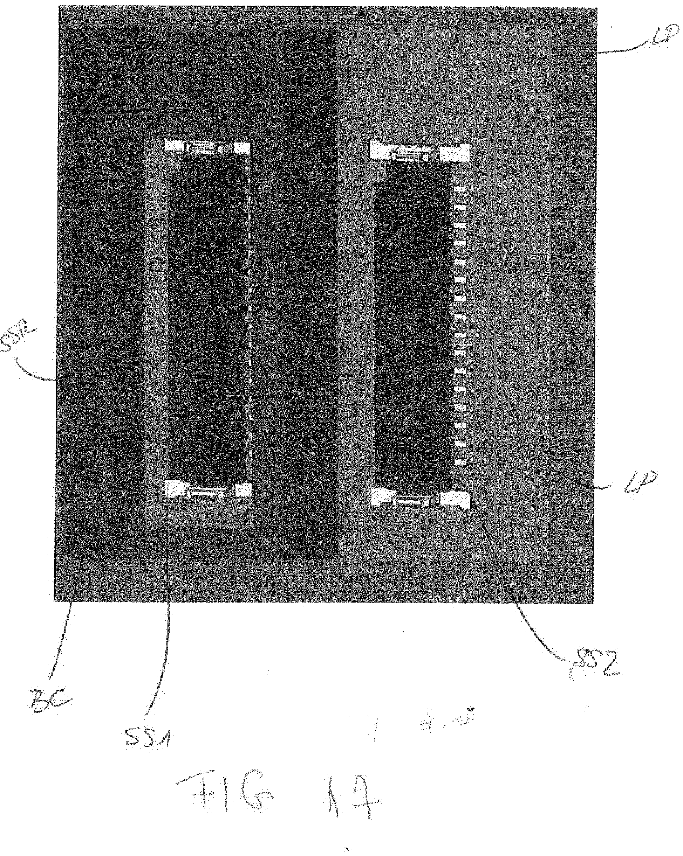

Mit der FIG 17 wird eine Ausschnittsdetaildarstellung der Leiterplatte LP und des ersten Signalsteckverbinders SS1 bzw. des zweiten Signalsteckverbinders SS2 dargestellt. Um den ersten Signalsteckverbinder SS1 befindet sich ein Ausschnitt eines Modulträgers BC mit dem entsprechenden Signalsteckverbinder-Raum SSR. Die Signalsteckverbinder SS,SS1,...,SS4 dienen dazu, Modul-Steckverbinder MS1,...,MS4 der jeweiligen Elektronikmodule EM aufzunehmen. In den jeweiligen Modulträgern BC ist ein erstes Elektronikmodul EM1, ein zweites Elektronikmodul EM2, ein drittes Elektronikmodul EM3 und ein viertes Elektronikmodul EM4 angeordnet. Rechts von dem vierten Elektronikmodul EM4 bildet ein Abschlussmodul ASM den Abschluss der Elektronikmodul EM.

Die Modulträger BC nehmen die Elektronikmodule EM1,...,EM4 auf. Zwischen einer Haupteinheit IM und dem ersten Elektronikmodul EM1 ist ein Adaptermodul AM angeordnet. Das Adaptermodul AM sorgt für eine Verbindung zwischen der Haupteinheit IM und dem ersten Elektronikmodul EM1, da die Elektronikmodule EM1,...,EM4 über die Modulträger BC auf der Leiterplatte LP angeordnet sind und die Haupteinheit IM auf einer Hutschiene HS angeordnet ist, ist das Adaptermodul AM ausgestaltet, den Höhenunterschied auszugleichen und eine elektrische Busverbindung zwischen der Haupteinheit IM und den Elektronikmodulen EM1,...,EM4 zu schaffen.

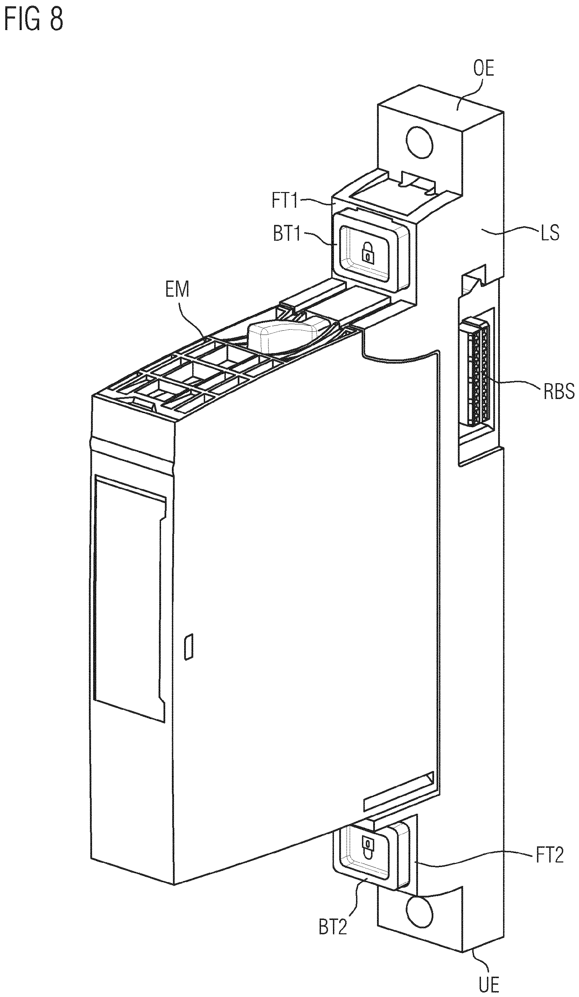

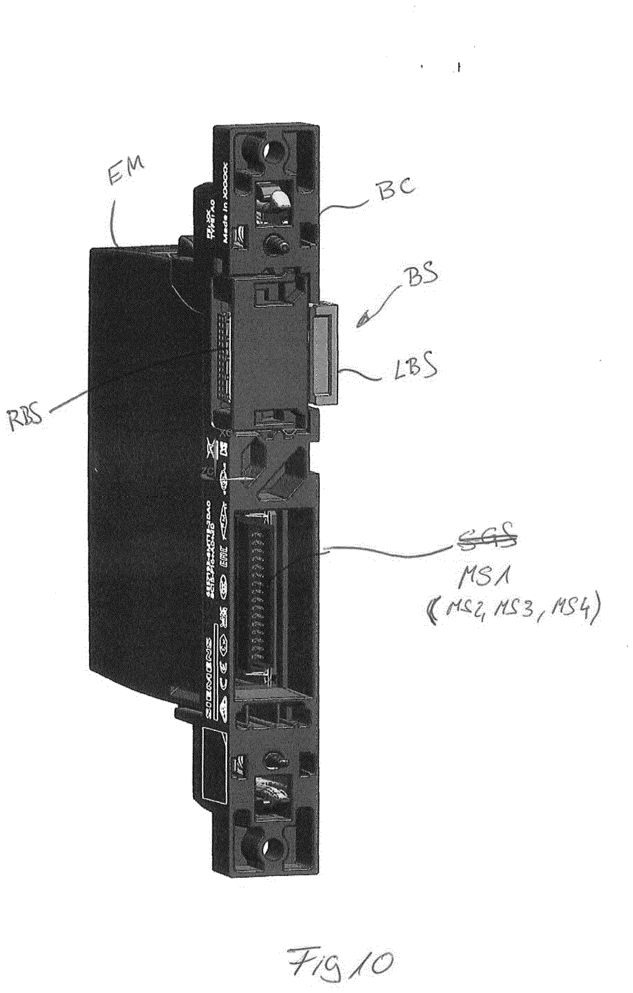

Ähnlich wie in FIG 8 dargestellt, zeigt die FIG 10 ein Elektronikmodul EM eingesteckt in einen Modulträger BC, allerdings mit Blick auf eine Unterseite. Das Elektronikmodul EM weist einen Modul-Steckverbinder MS1 auf, welcher in dem Signalsteckverbinder-Raum SSR angeordnet ist, und dort seinen Platz findet. Ist der Modulträger BC auf der Leiterplatte LP angeordnet, so kann der Modul-Steckverbinder MS1 in den entsprechenden Signalsteckverbinder SS1 auf der Leiterplatte LP elektrischen Kontakt finden.

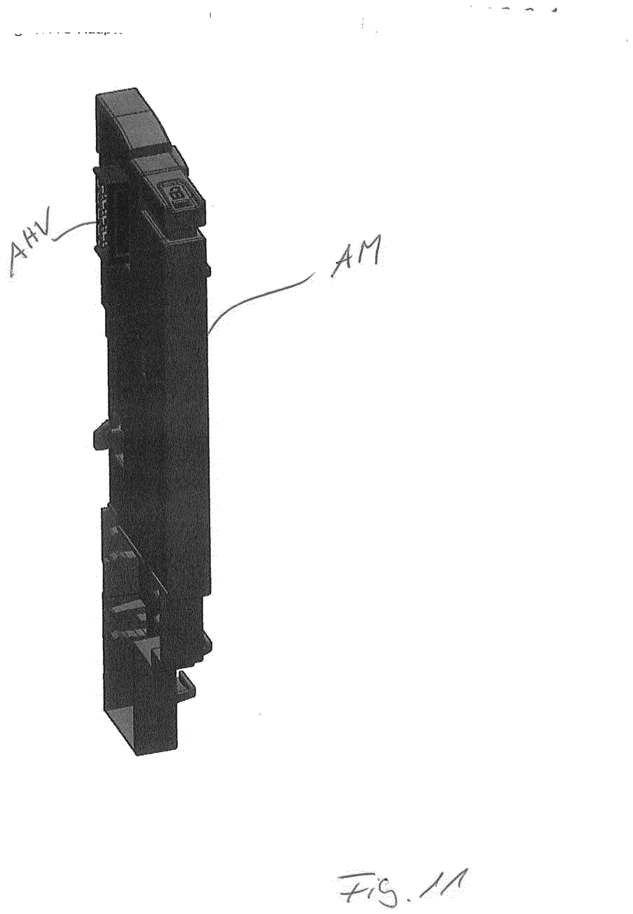

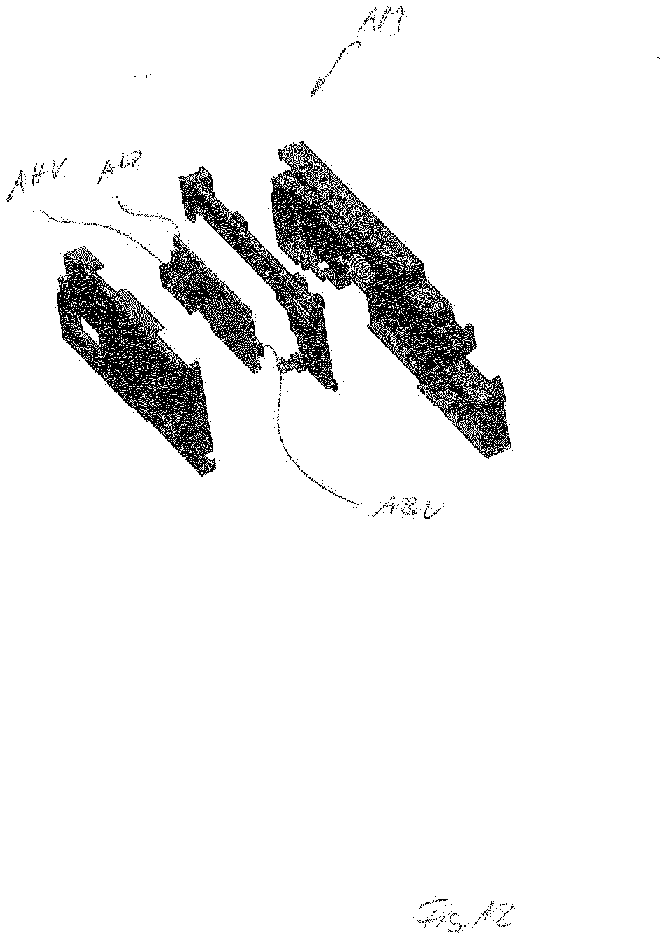

Mit der FIG 11 wird das Adaptermodul AM in einer perspektivischen Darstellung gezeigt. Da die Haupteinheit IM auf einer Hutschiene HS angeordnet ist, bildet das Adaptermodul AM eine Verbindung zwischen dem Bussteckverbinder BS des ersten Modulträgers BC und einem Stecker der Haupteinheit IM. Das Adaptermodul AM ist dabei ausgestaltet, mit einer Adapter-Leiterplatte ALP (siehe FIG 12) und einem Adapter-Haupteinheitsverbinder AHV.

Mit der FIG 12 ist das Adaptermodul AM in einer Explosionszeichnung dargestellt. Auf der Adapter-Leiterplatte ALP befindet sich der Adapter-Haupteinheitsverbinder AHV und ein Adapter-Busverbinder ABV, welche versetzt zueinander angeordnet sind um den Höhenunterschied zwischen Modulträger BC und Haupteinheit IM auszugleichen.

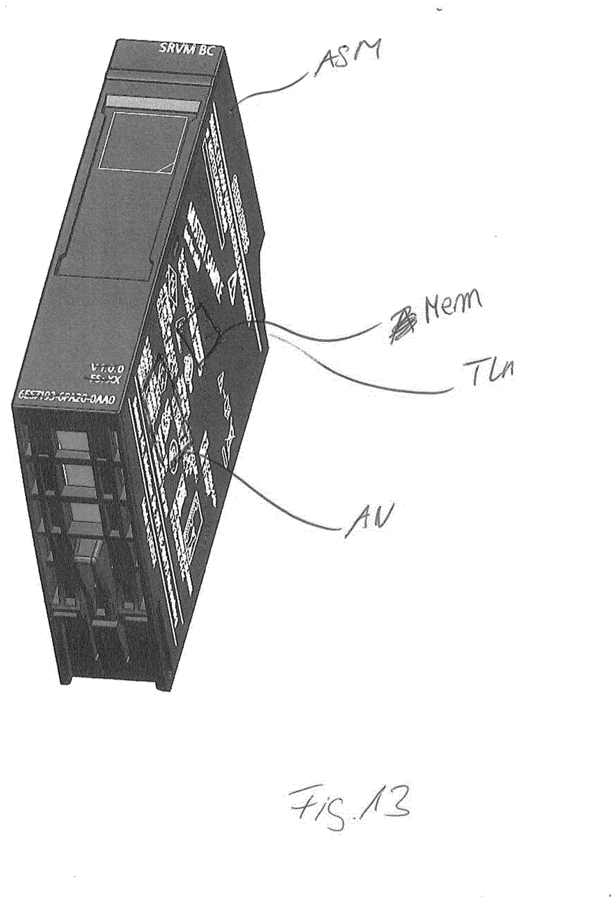

Die FIG 13 zeigt das Abschluss-Modul ASM. Das Abschlussmodul ASM hat in seinem Gehäuse ebenfalls eine Leiterplatte auf dem ein Abschluss-Netzwerk AN für den Rückwandbus angeordnet ist und zusätzlich trägt die Leiterplatte des Abschluss-Moduls ASM einen Speicherbaustein Mem für eine Teilnehmerkennung. Bei einer Parametrierung des Automatisierungssystems 1, erhält der Speicherbaustein Mem des Abschluss-Moduls ASM immer die Teilnehmerkennung Tln = letzter Teilnehmer.

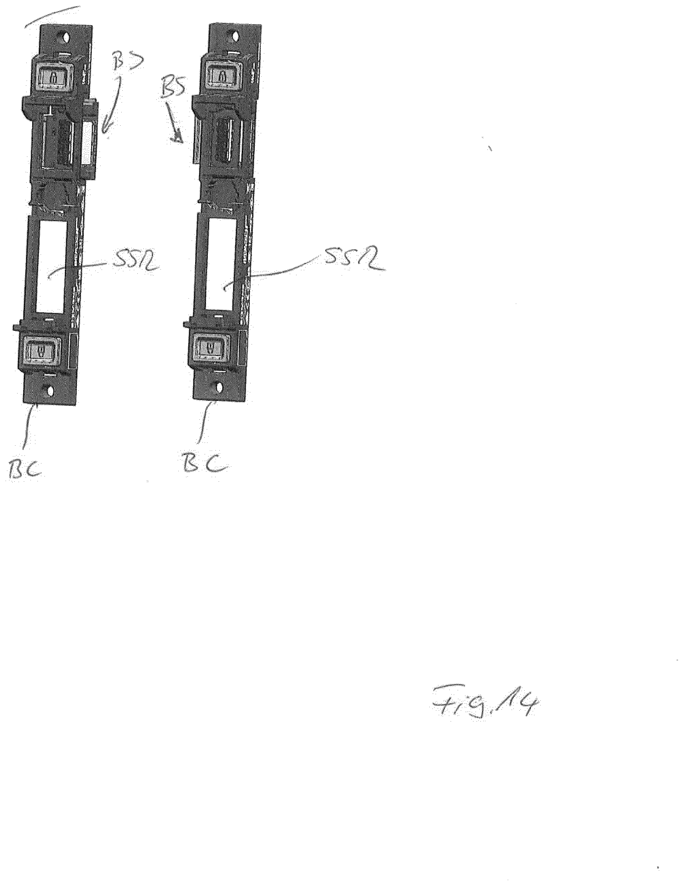

FIG 14 verdeutlicht noch einmal die Linksverschiebung des Bussteckverbinders BS um einen durchgehenden Rückwandbus RWS aufzubauen. Es sind zwei Modulträger BC nebeneinander dargestellt. Im linken Modulträger BC ist der Bussteckverbinder BS noch nicht nach links verschoben. Der rechte Modulträger BC zeigt den nach links verschobenen Bussteckverbinder BS, welcher dann bei nebeneinander angeordneten Modulträgern BC in den Bussteckverbinder BS des Vorgängermodulträgers BC einrasten kann und durch diese Linksverschiebung des Bussteckverbinders BS des Vorgängermodulträgers BC wird der Rückwandbus RWB aufgebaut.

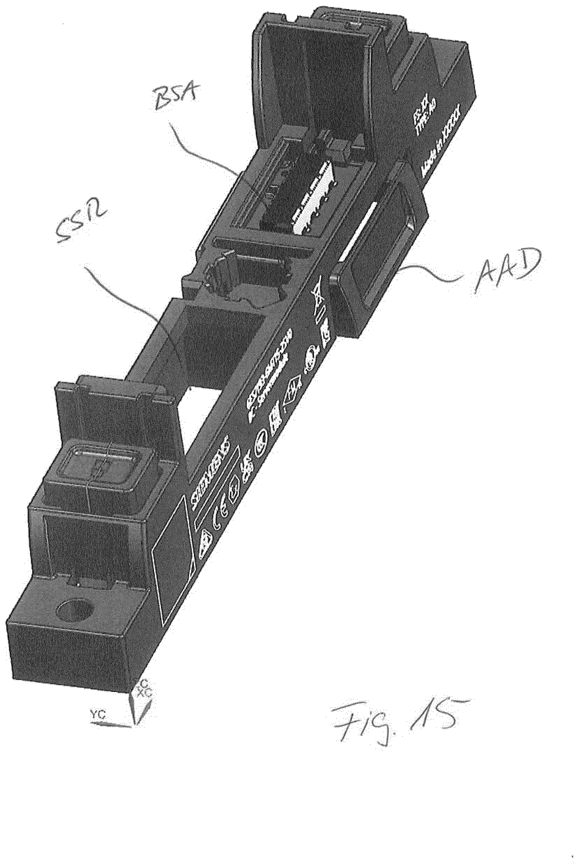

Gemäß FIG 15 ist speziell für das Abschluss-Modul ASM ein Abschluss-Modulträger ABC dargestellt. Wie auch die anderen Modulträger BC weist der Abschluss-Modulträger ABC einen Signalsteckverbinder-Raum SSR auf. Das besondere bei dem Abschluss-Modulträger ABC ist, dass sein Bussteckverbinder BS nur noch einmal den Linksseitigen Steckverbinder LBS und den Bussteckverbinder-Abschluss BSA aufweist. Zusätzlich ist noch eine Abschluss-Abdeckung AAD vorhanden, um vor Verschmutzung und elektrischen Kontakt des bzw. zu dem Rückwandbus zu schützen.

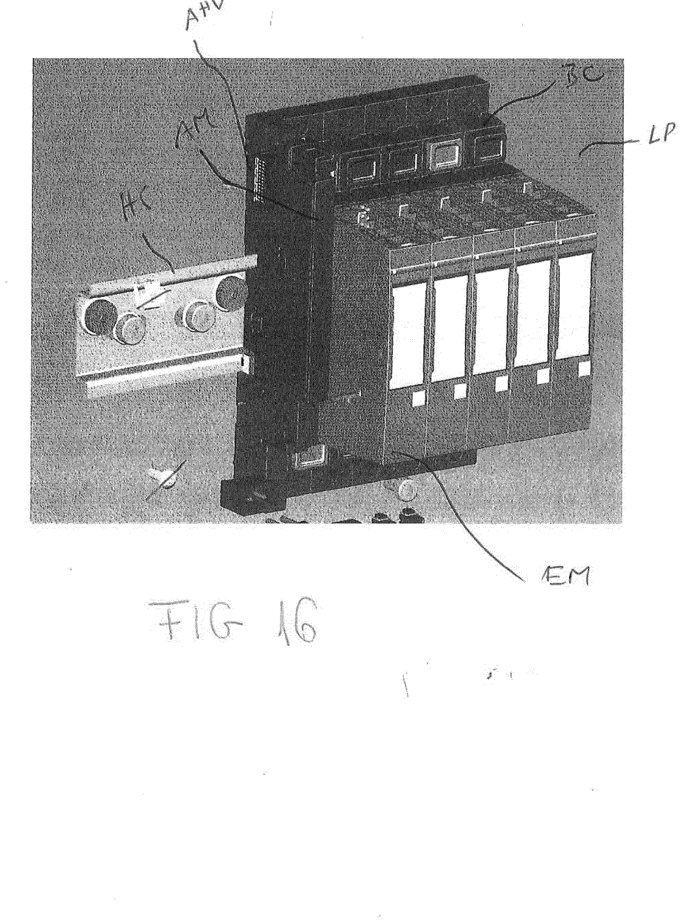

Die FIG 16 verdeutlicht nochmal die Anordnung der Hutschiene HS auf der Leiterplatte LP im Zusammenspiel mit der Anordnung der Modulträger BC auf der Leiterplatte LP. Wird auf der Hutschiene HS eine Haupteinheit IM aufgeschnappt und nach rechts verschoben, so kann die Bussteckverbinder-Verbindung der Haupteinheit IM in den Adapter-Haupteinheitsverbinder AHV des Adaptermoduls AM einrasten.

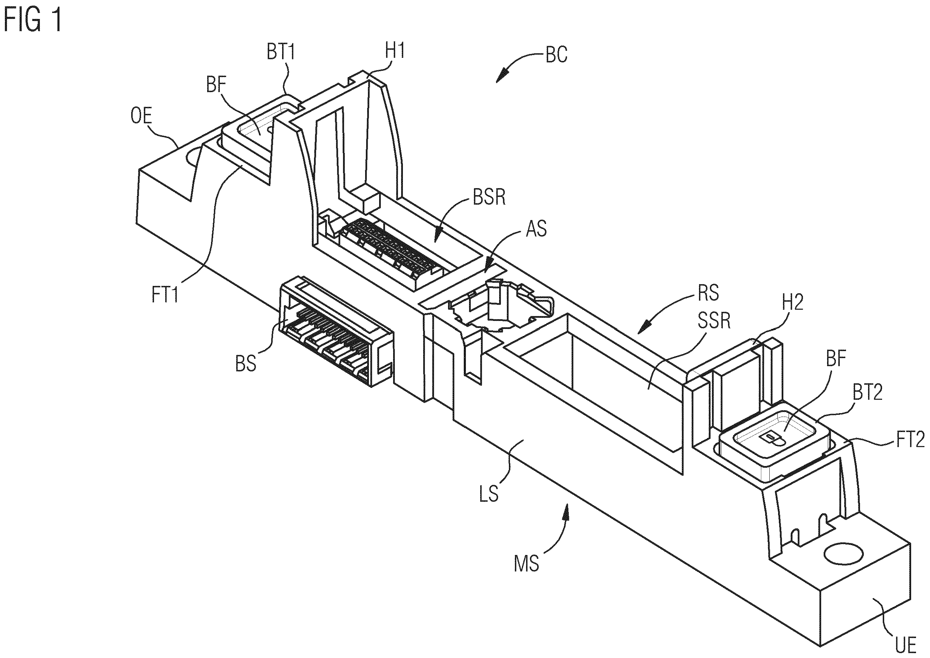

Gemäß FIG 1 ist ein Modulträger BC in einer perspektivischen Darstellung mit einer Sicht auf einer Linkeseite LS des Modulträgers BC dargestellt. Der Modulträger BC dient zur späteren Aufnahme eines Elektronikmoduls EM. Dazu umfasst der Modulträger BC eine Montageseite MS, ausgestaltet zur Montage auf einer Montageplatte MP, die Linkeseite LS, eine Rechteseite RS und eine Aufnahmeseite AS für das Elektronikmodul EM, welche der Montageseite MS gegenüberliegt. Des Weiteren weist der Modulträger BC ein oberes Ende OE und ein unteres Ende UE auf. Für eine Befestigung auf einer Montageplatte weist das obere Ende OE und das untere Ende UE jeweils eine Durchgangsbohrung auf. Für eine schnellere und einfachere Befestigung auf der Montageplatte MP weist der Modulträger BC nun im Bereich des oberen Endes OE ein erstes Befestigungsmittel BT1 und im Bereich des unteren Endes UE ein zweites Befestigungsmittel BT2 auf.

Das erste Befestigungsmittel BT1 und das zweite Befestigungsmittel BT2 sind derart ausgestaltet, dass jeweils ein Betätigungsteil BT1,BT2 beweglich in jeweils einem Führungsteil FT1,FT2 angeordnet ist. Dabei ist das Führungsteil FT1,FT2 ausgestaltet, dass sich das Betätigungsteil BT1,BT2 von der Aufnahmeseite AS durch Druck auf eine Bedienfläche BF durch eine Montageperson in Richtung der Montageseite MS verschieben lässt.

Hat nun eine Montageplatte MP, beispielsweise eine mehrlagige Leiterplatte, an der entsprechenden Stelle bereits eine Verrastbohrung, so kann mittels der Betätigungsteile BT1,BT2, welche jeweils einen Rasthaken RH aufweisen, der Modulträger BC rasch an der Leiterplatte befestigt werden.

Der Rasthaken RH ist dabei derart elastisch ausgebildet, dass er in einer ersten Stellung S1 des Betätigungsteils BT1,BT2 bereits eine Federkraft im Inneren des Führungsteils FT1,FT2 ausübt.

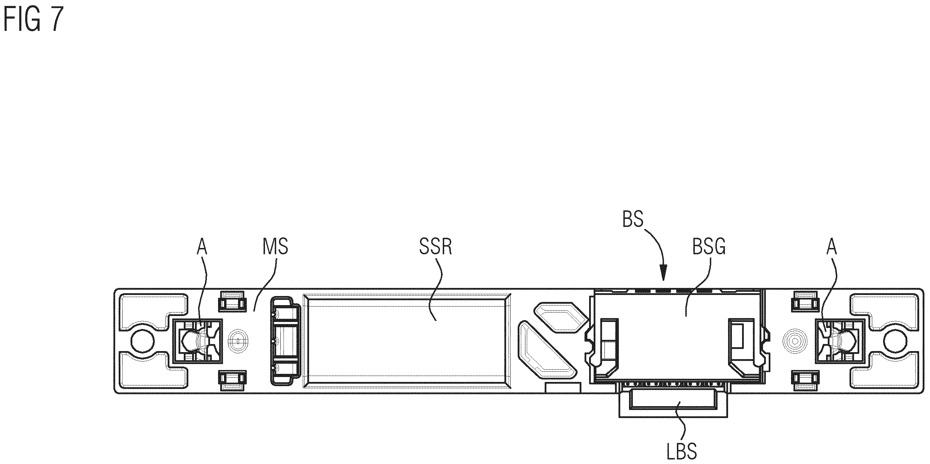

Da das Führungsteil FT1,FT2 eine in der Montageseite MS angeordnete Ausnehmung A aufweist (siehe FIG 7), kann der Rasthaken RH in einer zweiten Stellung S2 des Betätigungsteils BT1,BT2 mit seiner Rastnase RN die Ausnehmung A pasieren und in einer Öffnung O der Montageplatte MP eindringen bzw. durch sie hindurch dringen. Da der Rasthaken RH elastisch ausgebildet ist, wird er nun mit seiner Rastnase RN aus der Leiterplatte bzw. aus der Montageplatte MP herausspringen und sich hinter dieser Verhaken.

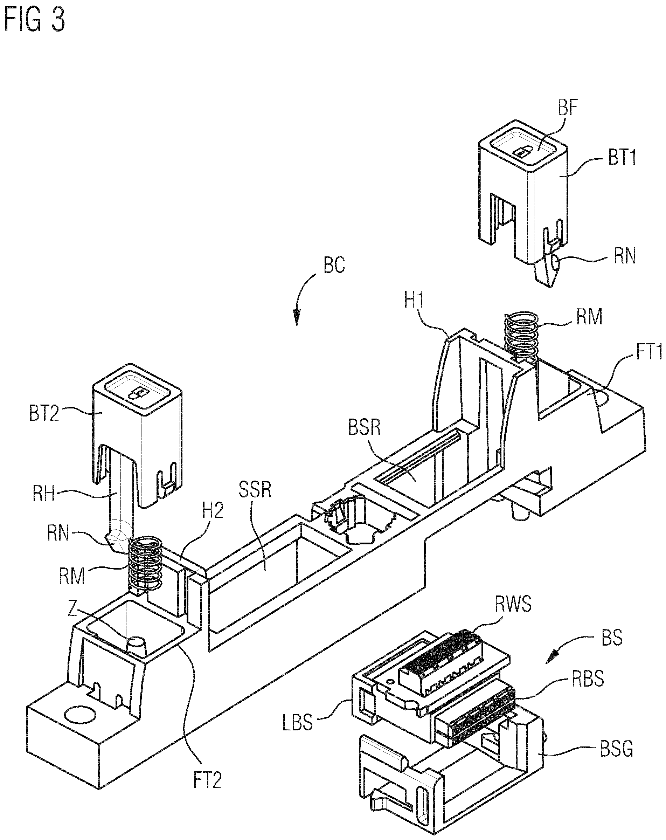

Zwischen der Montageseite MS, innerhalb des Führungsteils FT1,FT2, und dem Betätigungsteil BT1,BT2 ist ein Rückstellmittel RM angeordnet (siehe hierzu auch FIG 3, FIG 4 und FIG 5). In diesen Beispielen ist das Rückstellmittel RM als eine Spiralfeder ausgestaltet. Da die Spiralfeder zwischen dem Betätigungsteil BT1,BT2 und dem Führungsteil FT1,FT2 angeordnet ist, wird es das Betätigungsteil BT1,BT2 in Richtung der Aufnahmeseite AS zurückdrücken, nach dem eine Montageperson keinen Druck mehr auf die Bedienfläche BF ausübt. Nun kann das Betätigungsteil BT1,BT2 in einer Verriegelungsstellung SV derart verharren, dass die Rastnase RN gegen die Montageplatte MP drückt. Der Modulträger BC ist somit sicher auf der Montageplatte MP fixiert.

Zum sicheren Halten eines Elektronikmoduls EM, weist der Modulträger BC ein erstes Haltemittel H1 und ein zweites Haltemittel H2 auf.

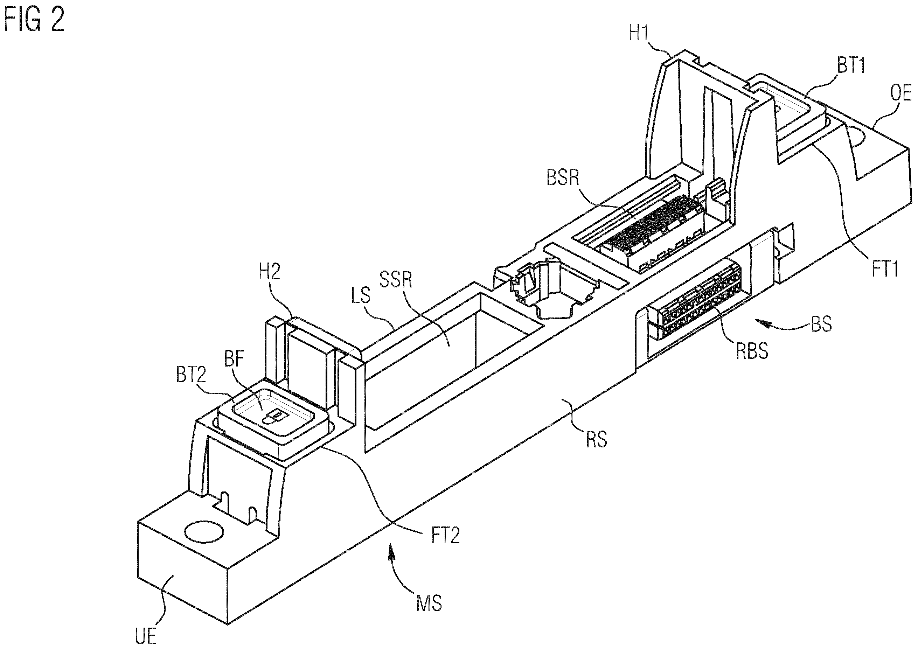

Gemäß FIG 2 ist der bereits bekannte Modulträger BC aus FIG 1, in einer anderen perspektivischen Darstellung mit Blick auf seine Rechteseite RS abgebildet. Wie auch in FIG 1 bereits gezeigt, weist der Modulträger BC einen Bussteckverbinder-Raum BSR und einen Signalsteckverbinder-Raum SSR auf. In dem Bussteckverbinder-Raum BSR ist ein Bussteckverbinder BS angeordnet und der Signalsteckverbinder-Raum SSR ist als Ausnehmung in der Montageseite MS ausgestaltet, um im montierten Zustand Raum für einen auf der Montageplatte MP befindlichen Signalsteckverbinder zu geben.

Der Modulträger BC nach FIG 1 oder FIG 2 ist ausgestaltet, durch Aneinanderreihen von einer Vielzahl von Modulträgern BC ein modular aufbaubares Automatisierungssystem zusammenzustellen. Die Bussteckverbinder BS sind dabei derart ausgestaltet, dass sie sich verschieben lassen und somit kann für mehrere Modulträger BC ein interner Rückwandbus durch die Bussteckverbinder BS aufgebaut werden.

Die FIG 3 verdeutlicht in einer Explosionsdarstellung des Modulträger BC noch einmal die Einbaulagen der Betätigungsteile BT1,BT2 und der Führungsteile FT1,FT2, insbesondere aber den verschiebbaren Einbau des Bussteckverbinders BS.

Der Bussteckverbinder BS ist wiederum in ein Bussteckverbinder-Gehäuse BSG eingebettet. Der Bussteckverbinder-Raum BSR innerhalb des Modulträgers BC und der Bussteckverbinder BS sind derart ausgestaltet, dass der Bussteckverbinder BS mit seinem Bussteckverbinder-Gehäuse BSG in dem Bussteckverbinder-Raum BSR verschiebbar angeordnet ist. Der Bussteckverbinder BS umfasst dabei einen zur Linkeseite LS angeordneten Linksseitigen-Stecker LBS, einen zur Rechteseite RS angeordneten Rechtsseitigen-Stecker RBS und zur Aufnahmeseite AS angeordneten Rückwandbus-Stecker RWS.

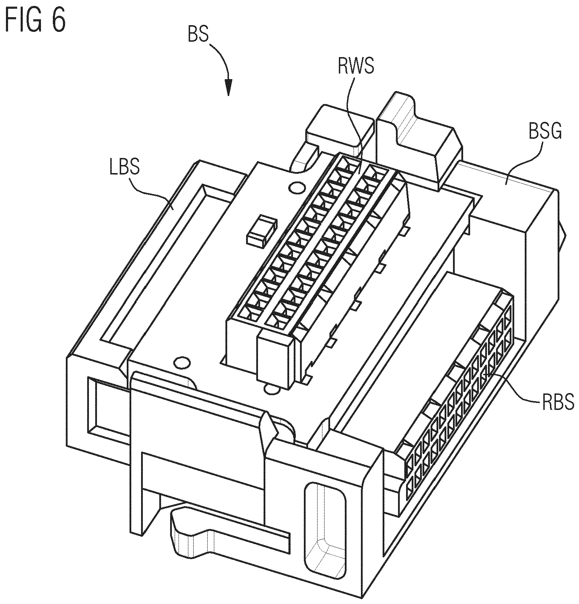

Unter Zuhilfenahme von FIG 6 kann nun der technische Effekt für das verschiebbare angeordnete Bussteckverbinder-Gehäuse BSG erläutert werden. Das Bussteckverbinder-Gehäuse BSG ist ausgestaltet, mit dem entsprechend ausgestalteten Bussteckverbinder-Raum BSR bei einer Linksverschiebung einzurasten, so dass der Linksseitige-Stecker LBS mit einem jeweiligen Rechtsseitigen-Stecker RBS eines Bussteckverbinders BS eines Vorgängermodulträger im Eingriff steht und dass sich der Rückwandbus-Stecker RWS in einer Mittelstellung befindet, damit ein über die Aufnahmeseite AS einsteckbares Elektronikmodul EM mit einem Gegenrückwandbus-Stecker GRS mit dem Rückwandbus-Stecker RWS im Kontakt steht.

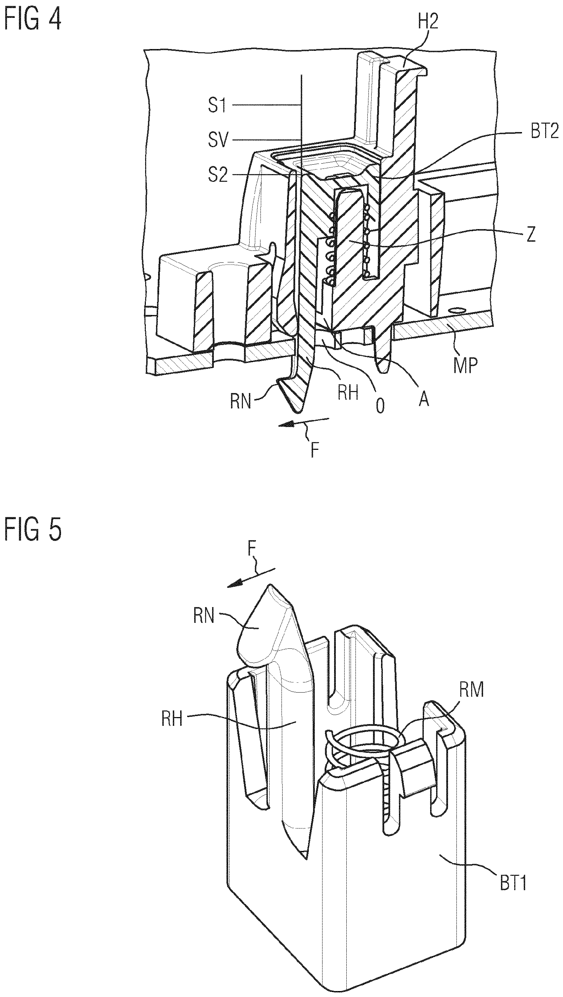

Mit der FIG 4 wird in einer Schnittdarstellung durch den Modulträger BC mit Blick auf das zweite Führungsteil FT2 und das zweite Bedienteil BT2, die Funktion des Rasthakens RH mit seiner Rastnase RN bei Druck auf die Bedienfläche BF durch eine Montageperson klar. Das zweite Betätigungsteil BT2 wird durch Druck auf die Bedienfläche BF von einer ersten Position S1 in eine zweite Position S2 verschoben. Die zweite Position S2 bzw. die zweite Stellung S2 ist derart tief angeordnet, dass der Rasthaken RH mit seiner Rastnase RN das zweite Führungsteil FT2 bzw. dessen Innenseite verlässt und durch eine Ausnehmung A hindurch durch eine Verrastbohrung in der Montageplatte MP dringt und sich nun die elastische Federkraft des Rasthakens RH bemerkbar macht und der Rasthaken RH mit der Kraft F gegen die Leiterplatte drückt. Wird die Bedienperson den Druck auf die Bedienfläche BF nachlassen, so verruscht das zweite Betätigungsteil BT2 in eine Verriegelungsstellung SV und die Rastnase RN drückt den Modulträger BC an die Leiterplatte heran. Da zwischen dem zweiten Bedienteil BT2 und dem zweiten Führungsteil FT2 ein Rückstellmittel RM auf einem Zapfen Z angeordnet ist, wird das zweite Bedienteil BT2 bei nachlassendem Druck nach oben gedrückt.

Die FIG 5 verdeutlicht das erste Betätigungsteil BT1 in einer perspektivischen Darstellung als ein Kunststoffspritzgussteil mit seinem entsprechenden Rasthaken RH und seiner Rastnase RN, wobei die Rastnase RN und der Rasthaken RH derart elastisch ausgeformt wird, dass eine Kraft F in der Richtung wie eingezeichnet entsteht. Als Rückstellmittel RM wird eine Spiralfeder im Inneren des ersten Betätigungsteils BT1 angeordnet.

Die FIG 6 zeigt wiederum in einer perspektivischen Darstellung den Bussteckverbinder BS, wie er in dem Bussteckverbinder-Gehäuse BSG angeordnet ist. Das Bussteckverbinder-Gehäuse BSG weist ebenfalls Verrasthaken mit Rastnasen auf, welche dazu dienen, wie mit FIG 7 mit Blick auf die Montageseite MS gezeigt, in entsprechende Verrastöffnungen in dem Modulträger BC einzurasten.

Wie in FIG 7 gezeigt ist der Modulträger BC mit Blick auf die Montageseite MS dargestellt. Der Bussteckverbinder BS mit seinem Bussteckverbinder-Gehäuse BSG ist bereits ganz in den Modulträger BC nach links eingeschoben worden, wobei die erwähnten Verrasthaken und Verrastnasen aus FIG 6 in einer Stellung eingerastet sind, so dass der Linksseitige-Stecker LBS aus dem Modulträger BC herausragt. Wäre nun an dieser Stelle ein weiterer Modulträger BC angeordnet, so würde der Linksseitige-Stecker LBS in den entsprechenden Rechtsseitigen-Stecker RBS des benachbarten Modulträgers BC einrasten.

Abschließend sei mit FIG 8 die Einheit Elektronikmodul EM und Modulträger BC dargestellt. Die Bedienflächen BF der Bedienteile BT1,BT2 sind mit einer strukturierten Oberfläche versehen. In diesem Ausführungsbeispiel ist die strukturierte Oberfläche in Form eines Schlosses dargestellt, welches zum Ausdruck bringt, wenn man dieses drückt wird hier verriegelt.

Zusammenfassend kann gesagt werden:
Die Verrastung von Baugruppen auf Leiterplatten stellt mehrere Herausforderungen dar, darunter Toleranzausgleich, Funktionalität bei unterschiedlichen Leiterplattendicken und die Notwendigkeit einer fertigungsfreundlichen Rastkontur. Leiterplatten haben typischerweise eine Toleranz von 10% der Nennmaßdicke, was die Verrastung erschwert. Kundenspezifische Anforderungen erfordern die Verwendung verschiedener Leiterplattendicken.

Ein Mitbewerberprodukt verwendet nicht-gefederte Kunststoff-rasthaken, die nur für 1,6mm dicke Leiterplatten geeignet sind und keinen Toleranzausgleich bieten. Für dickere Leiterplatten ist eine kostenintensive Tiefenfräsung erforderlich.

Die vorgestellte Lösung besteht aus einem Rückstellmittel, insbesondere aus einer Metallfeder, und einem Kunststoffteil mit abgerundetem Rasthaken. Diese Konstruktion ermöglicht die Verwendung von Leiterplatten mit beispielsweise 1,6mm bis 2,7mm Nennmaß (±10% Toleranz). Der Rasthaken greift durch eine Bohrung in der Leiterplatte und wird durch die Feder gegen die Rückseite gedrückt.

Hauptvorteile dieser Lösung sind:
1. Vollständiger Toleranzausgleich durch Federlagerung.
2. Spielfreie Montage auf unterschiedlich dicken Leiterplatten.
3. Konstante Federkraft für sichere Befestigung.
4. Flexibilität bei der Verwendung verschiedener Leiterplattendicken.
5. Unterstützung kostengünstiger Fertigungsmethoden durch Bohrungen statt Fräsungen.

## Patentansprüche

1. Modular aufgebautes Automatisierungssystem (1)
umfassend
- eine Leiterplatte (LP),
- eine Mehrzahl an Anschlussmitteln(B1,B2,B3,B4), welche auf der Leiterplatte (LP) angeordnet sind,
- eine Mehrzahl von Signalsteckverbindern (SS), welche ebenfalls auf der Leiterplatte (LP) angeordnet sind, und ausgestaltet sind Modul-Steckverbinder (MS1,..,MS3) eines Elektronikmoduls (EM) aufzunehmen,
wobei die Anschlussmitteln(B1,B2,B3,B4) über Leiterbahnen der Leiterplatte (LP) mit den Signalsteckverbindern (SS1,...,SS4) in Verbindung stehen,
wobei die Anschlussmittel (B1,B2,B3,B4) ausgestaltet sind für den Anschluss an Prozess-Signalkabel,
g**ekennzeichnet, durch** mindestens einen
Modulträger (BC) mit aufgenommenen Elektronikmodul (EM), der Modulträger (BC) weist einen Bussteckverbinder-Raum (BSR) und einen Signalsteckverbinder-Raum (SSR) auf, wobei in dem Bussteckverbinder-Raum (BSR) ein Bussteckverbinder (BS) angeordnet ist und der Signalsteckverbinder-Raum (SSR) ist als Ausnehmung ausgestaltet, um in einem montierten Zustand des Modulträgers (BC) auf der Leiterplatte (LP) Raum für den auf der Leiterplatte (LP) befindlichen Signalsteckverbinder (SS) zu geben,
wobei der Bussteckverbinder-Raum (BSR) und der Bussteckverbinder (BS) ausgestaltet sind, dass der Bussteckverbinder (BS) in dem Bussteckverbinder-Raum (BSR) verschiebbar angeordnet ist, dabei umfasst der Bussteckverbinder (BS) einen Linksseitigen-Stecker (LBS), einen Rechtsseitigen-Stecker (RBS) und einen zum Modulträger (BC) angeordneten Rückwandbus-Stecker (RWS), welcher ausgestaltet ist einem Modulrückwandbus-Gegenstecker (RWG) des Elektronikmodul (EM) aufzunehmen, wobei der Modulträger (BC) ausgestaltet ist **durch** Aneinanderreihen von einer Vielzahl von Modulträgern (BC) das modular aufbaubare Automatisierungssystem (1) zusammenzustellen, wobei ein Bussteckverbinders (BS) eines Vorgänger-Modulträger (BC) **durch** eine Linksverschiebung des Bussteckverbinders (BS) eines Nachfolger-Modulträgers (BC) mit diesem verbindbar ist, wodurch ein Rückwandbus für das modular aufbaubare Automatisierungssystem (1) gebildet ist.

2. Modular aufgebautes Automatisierungssystem (1) nach Anspruch 1, wobei der Bussteckverbinders (BS) eine Busleiterplatte (BLP) umfasst, welche den Linksseitigen-Stecker (LBS), den Rechtsseitigen-Stecker (RBS) und den Rückwandbus-Stecker (RWS) trägt.

3. Modular aufgebautes Automatisierungssystem (1) nach Anspruch 1 oder 2, umfassend eine Haupteinheit (IM), wobei zwischen der Haupteinheit (IM) und einem ersten Modulträger (BC) ein Adaptermodul (AM) angeordnet ist, wobei das Adaptermodul (AM) ausgestaltet ist mit einer Adapterleiterplatte (ALP), auf welcher ein Adapter-Haupteinheitsverbinder (AHV) und ein Adapter-Busverbinder (ABV) versetzt zueinander angeordnet sind.

4. Modular aufgebautes Automatisierungssystem (1) nach Anspruch 3, wobei die Haupteinheit (IM) auf einer Hutschiene (HS) angeordnet ist.

5. Modular aufgebautes Automatisierungssystem (1) nach einem der Ansprüche 1 bis 4, umfassend ein Abschluss-Modul (ASM), welches ein Abschluss-Netzwerk (AN) für den Rückwandbus aufweist und ein Speicherbaustein (Mem) für eine Teilnehmerkennung (Tln) aufweist.

6. Modular aufgebautes Automatisierungssystem (1) nach Anspruch 5, wobei das Abschluss-Modul (ASM) in einem Abschluss-Modulträger (ABC) mit einer Abschluss-Abdeckung angeordnet ist.

7. Modular aufgebautes Automatisierungssystem (1) nach einem der Ansprüche 1 bis 6, wobei der Modulträger (BC) ausgestaltet ist mit
- einer Montageseite (MS) ausgestaltet zu Montage auf der Leiterplatte (LP),
- einer Linkeseite (LS),
- einer Rechteseite (RS),
- einer Aufnahmeseite (AS) für das Elektronikmodul (EM), welche der Montageseite (MS) gegenüberliegt,
- einem oberen Ende (OE) und
- einem unteren Ende (UE),
wobei zur Befestigung auf der Leiterplatte (LP) im Bereich des oberen Endes (OE) ein erstes Befestigungsmittel (BT1) angeordnet ist und im Bereich des unteren Endes (UE) ein zweites Befestigungsmittel (BT2) angeordnet ist,
wobei das Befestigungsmittel derart ausgestaltet ist, dass ein Betätigungsteil (BT1,BT2) beweglich in einem Führungsteil (FT1,FT2) angeordnet ist, dabei ist das Führungsteil (FT1,FT2) ausgestaltet, dass das Betätigungsteil (BT1,BT2) von der Aufnahmeseite (AS) durch Druck auf eine Bedienfläche (BF) durch eine Montageperson in Richtung der Montageseite (MS) verschiebbar ist, wobei das Betätigungsteil (BT1,BT2) einen Rasthaken(RH) aufweist, welcher derart elastisch ausgebildet ist, dass in einer ersten Stellung (S1) des Betätigungsteils (BT1,BT2) eine Federkraft des Rasthakens(RH) eine am Ende des Rasthakens(RH) angeordnete Rastnase (RN) gegen eine Innenfläche des Führungsteils (FT1,FT2) drückt, wobei das Führungsteil (FT1,FT2) eine in der Montageseite (MS) angeordnete Ausnehmung (A) aufweist, wobei in einer zweiten Stellung (S2) des Betätigungsteils (BT1,BT2) der Rasthaken (RH) mit der Rastnase (RN) die Ausnehmung (A) und eine Öffnung (O) in der Montageplatte (MP) durchdringt, wobei zwischen der Montageseite (MS) innerhalb des Führungsteils (FT1,FT2) und dem Betätigungsteil (BT1,BT2) ein Rückstellmittel (RM) angeordnet ist, welches das Betätigungsteil (BT1,BT2) in Richtung der Aufnahmeseite (AS) derart zurückführt, dass das Betätigungsteil (BT1,BT2) in einer Verriegelungsstellung (SV) verharrt und die Rastnase (RN) gegen die Leiterplatte (LP) drückt.

8. Modular aufgebautes Automatisierungssystem (1) nach einem der Ansprüche 1 bis 7, wobei der Modulträger (BC) ein Aufnahmemittel für das Elektronikmodul (EM) umfassend ein erstes Haltelement (H1) und ein zweites Halteelement (H2) die Halteelemente (H1,H2) sind sich derart gegenüber angeordnet, dass das Elektronikmodul (EM) dazwischen einsteckbar ist.

9. Modular aufgebautes Automatisierungssystem (1) nach einem der Ansprüche 1 bis 8, wobei der Modulträger (BC) ein Bussteckverbinder-Gehäuse (BSG) als eine Aufnahme für den Bussteckverbinder (BS) umfasst, und dabei ist das Bussteckverbinder-Gehäuse (BSG) ausgestaltet mit dem entsprechend ausgestalteten Bussteckverbinder-Raum (BSR) bei einer Links-verschiebung einzurasten, so dass der Linksseitige-Stecker (LBS) mit einem Rechtsseitigen-Stecker (RBS) eines Bussteckverbinders (BS) eines Vorgänger-Modulträgers im Eingriff steht und das sich der Rückwandbus-Stecker (RWS) in einer Mittelstellung befindet, damit ein über die Aufnahmeseite (AS) einsteckbares Elektronikmodul (EM) mit einem Gegen-Rückwandbus-Stecker mit dem Rückwandbus-Stecker (RWS) im Kontakt steht.
